## Europäisches Patentamt

## European Patent Office

## Office européen des brevets

(11) Veröffentlichungsnummer: **0 288 835 B1**

(12) # EUROPÄISCHE PATENTSCHRIFT

(45) Veröffentlichungstag der Patentschrift:
04.04.90

(51) Int. Cl.⁴: **G01R 33/38**, G01R 33/42, H01F 7/22

(21) Anmeldenummer: **88105998.4**

(22) Anmeldetag: **14.04.88**

(54) **Magnetsystem einer Anlage zur Kernspintomographie mit supraleitenden Einzelspulen und einem Kälteschild.**

(30) Priorität: **27.04.87 DE 3714017**

(43) Veröffentlichungstag der Anmeldung:
**02.11.88 Patentblatt 88/44**

(45) Bekanntmachung des Hinweises auf die Patenterteilung:
**04.04.90 Patentblatt 90/14**

(84) Benannte Vertragsstaaten:
**DE FR GB NL**

(56) Entgegenhaltungen:
EP-A- 0 156 239
DE-A- 1 763 771
DE-A- 3 344 047
DE-B- 1 212 626
US-A- 4 291 541

CRYOGENICS, Band 24, Nr. 2, Februar 1984, Seiten 59-62, Butterworth & Co. (Publishers) Ltd, Guildford, Surrey, GB; K. PIETERMAN et al.: "A 1.5 T superconducting magnet with closed cooling system for spin-imaging: an outline"
JAPANESE JOURNAL OF APPLIED PHYSICS, Band 25, Nr. 6, Juni 1986, Seiten L443-L445, Tokyo, JP; A. YAMAMOTO et al.: "Quench characteristics and operational stability of the TOPAZ thin superconducting solenoid"

(73) Patentinhaber: **Siemens Aktiengesellschaft, Wittelsbacherplatz 2, D-8000 München 2(DE)**

(72) Erfinder: **Schmettow, Dieter, Dr., Ludwig-Sand-Strasse 3, D-8520 Erlangen(DE)**
Erfinder: **Ries, Günter, Dr., Schobertweg 2, D-8520 Erlangen(DE)**

## Beschreibung

Die Erfindung bezieht sich auf ein Magnetsystem einer Anlage zur Kernspintomographie mit mindestens einem Paar ringförmiger supraleitender Einzelspulen zur Erzeugung eines homogenen magnetischen Grundfeldes, wobei zumindest die an den beiden Stirnseiten des Magnetsystems befindlichen supraleitenden Einzelspulen jeweils mit einer Schutzvorrichtung für den Fall eines unbeabsichtigten Normalleitendwerdens (Quench) elektrisch überbrückt sind, mit normalleitenden Spulen zur Ausbildung magnetischer Feldgradienten sowie mit einem hohlzylindrischen Kälteschild aus normalleitendem Material, der zwischen den Gradientenspulen und den supraleitenden Einzelspulen angeordnet und in axialer Richtung zumindest bis zu den beiden Stirnseiten ausgedehnt ist. Ein derartiges Magnetsystem geht im wesentlichen aus der DE-A 33 44 047 hervor.

Auf dem Gebiet der medizinischen Technik sind bildgebende Diagnoseverfahren entwickelt worden, bei denen rechnerisch oder meßtechnisch integrale Resonanzsignale von Kernen eines bestimmten chemischen Elementes eines zu untersuchenden, insbesondere menschlichen Körpers oder Körperteiles analysiert werden. Aus der so zu gewinnenden räumlichen Spindichte- und/oder Relaxationszeitverteilung läßt sich dann ein Bild ähnlich einem Röntgentomogramm der Computertomographie rekonstruieren bzw. berechnen. Entsprechende Verfahren sind unter der Bezeichnung "Kernspintomographie" (bzw. Nuclear Magnetic Resonance Tomography - NMR-Tomographie, auch als "Magnetic Resonance Imaging - MRI" oder "Magnetic Resonance Spectroscopy - MRS" bezeichnet) oder "Zeugmatographie" bekannt.

Voraussetzung für die Kernspintomographie ist ein von einem sogenannten Grundfeldmagneten erzeugtes Magnetfeld, das in einem Abbildungs- bzw. Untersuchungsbereich hinreichend homogen sein muß und dessen magnetische Induktion dort bis zu mehreren Tesla betragen kann. Derartige magnetische Induktionen lassen sich wirtschaftlich jedoch nur mit supraleitenden Magneten erzeugen. In den Untersuchungsbereich wird dann ein zu untersuchender Körper bzw. Körperteil längs einer Achse, die im allgemeinen mit der Orientierungsachse des magnetischen Grundfeldes übereinstimmt, eingebracht. Dieses Grundfeld ist von stationären und/oder gepulsten, sogenannten Gradientenfeldern überlagert. Zur Anregung der einzelnen Atomkerne in dem Körper bzw. Körperteil zu einer Präzessionsbewegung ist außerdem eine besondere Antenneneinrichtung erforderlich, mit der kurzzeitig ein hochfrequentes magnetisches Wechselfeld angeregt werden kann. Gegebenenfalls läßt sich diese Antenneneinrichtung auch zum Empfang der so hervorgerufenen hochfrequenten Signale vorsehen.

Größere supraleitende Magnete, wie sie z.B. für Anlagen zur Kernspintomographie vorgesehen werden, können erhebliche Energiemengen speichern, die vielfach im MJ-Bereich liegen. Insbesondere derartige Magnete sind bei einem unbeabsichtigten Übergang vom supraleitenden Betriebszustand in den normalleitenden Zustand stark gefährdet, selbst wenn dieser auch als "Quench" bezeichnete Übergang zunächst nur in einem Teil des Magneten auftritt. Infolge der geringen Wärmekapazität der supraleitenden Spulenleiter des Magneten nimmt nämlich ein solcher Leiter nach einem Quench durch die dadurch bedingte Widerstandserhöhung sehr schnell eine hohe Temperatur an. Gleichzeitig steigt auch sein spezifischer Widerstand sehr rasch, wodurch die Erwärmung noch beschleunigt wird. Es kommt dabei zu elektrischen Überspannungen, welche die Isolation beanspruchen und bei einem Überschlag zu einer Beschädigung oder Zerstörung des Magneten führen können.

Um derartige supraleitende Magnete vor einer Beschädigung oder Zerstörung durch Überhitzung bzw. durch elektrische Überschläge zu schützen, sind besondere Maßnahmen erforderlich. Diese Maßnahmen können z.B. darin bestehen, daß man den Magneten in mehrere Einzelspulen unterteilt, die außerdem zur Spannungsbegrenzung jeweils mit einer eigenen Schutzvorrichtung elektrisch überbrückt sind. Derartige Schutzvorrichtungen können insbesondere ohmsche Schutzwiderstände (vgl. DE-A 23 01 152), Halbleiterdioden (DE-A 16 14 964) oder auch Überspannungsableiter (vgl. DE-A 17 64 369) sein.

Die supraleitenden Grundfeldmagnete für eine Anlage zur Kernspintomographie können insbesondere aus mehreren Paaren ringförmiger supraleitender Einzelspulen aufgebaut sein und weisen dann Solenoidform auf (vgl. z.B. EP-A-0 105 565 oder die eingangs genannte DE-A). Diese supraleitenden Einzelspulen lassen sich vorteilhaft mit den genannten Quenchschutzvorrichtungen elektrisch überbrücken. Dann können aber bei einem Quench einer einzelnen Spule die Ströme der im allgemeinen in Serie geschalteten Spulen des Magneten einen stark unterschiedlichen zeitlichen Verlauf annehmen, so daß die ansonsten symmetrische Strom- und folglich auch die Feldverteilung stark asymmetrisch wird. Entsprechendes gilt in der Folge auch für eine Wechselwirkung der Spulen mit ihrer Umgebung. So werden in den Wänden eines sie umgebenden Kryostaten, insbesondere aber in sie umgebenden tiefgekühlten Strahlungs- bzw. Kälteschilden unerwünschte Kreisströme induziert. Aus Gründen einer hohen elektromagnetischen Zeitkonstante, durch welche Wirbelstromeffekte auf die Gradientenfelder verringert werden, sind dem Untersuchungsbereich zugewandte Strahlungsschilde vorzugsweise aus dickwandigen Rohren gefertigt, die aus elektrisch gut-leitendem Material bestehen. Hier können dann aber hohe quenchinduzierte Ströme und in Zusammenwirkung mit dem Spulenfeld axiale Summenkräfte im Bereich mehrerer Tonnen auftreten, welche eine mechanische Aufhängung oder Abstützung der supraleitenden Spulen entsprechend belasten. Die größten Kräfte entstehen dabei bei einem Quench einer der stirnseitigen einzelnen Spulen eines Mehrspulensystems, wie es für Kernspintomographie-Grundfeldmagnete vielfach vorgesehen wird.

Aufgabe der vorliegenden Erfindung ist es deshalb, das Magnetsystem der eingangs genannten Art dahingehend zu verbessern, daß diese Kraftwirkung bei einem Quench vermindert wird.

Diese Aufgabe wird erfindungsgemäß dadurch gelöst, daß der Kälteschild an den beiden Stirnseiten durch rohrförmige Endstücke gebildet ist, deren Material einen vorbestimmten spezifischen elektrischen Widerstand hat, der bei Betriebstemperatur des Schildes größer ist als der spezifische elektrische Widerstand des Materials, aus dem mindestens ein sich zwischen den Endstücken erstreckendes, zumindest den Bereich der Gradientenspulen überdeckendes rohrförmiges Zwischenstück des Kälteschildes besteht.

Gemäß dieser Ausgestaltung des Magnetsystems befinden sich also die Endstücke aus dem elektrisch schlechter leitenden Material zumindest zum Teil im Bereich der stirnseitigen supraleitenden Einzelspulen. Die damit verbundenen Vorteile sind dann darin zu sehen, daß die bei einem Quench einer dieser Spulen in den zugeordneten Endstücken des Kälteschildes angeworfenen Wirbelströme entsprechend verringert sind. Dies hat außerdem zur Folge, daß auch die Kraftwirkung auf dem Kälteschild entsprechend begrenzt ist. Da ferner das Zwischenstück des Kälteschildes, das den von den Gradientenspulen eingenommenen Bereich räumlich von den supraleitenden Einzelspulen trennt, aus elektrisch gut-leitendem Material besteht, wird vorteilhaft eine hohe elektromagnetische Zeitkonstante gewährleistet. Hiermit ist eine Wirbelstromkompensation erleichtert und außerdem der Felddurchgriff des Gradientenfeldes auf die supraleitenden Einzelspulen, der zu erhöhten Kühlmittelverlusten führen würde, entsprechend begrenzt.

Eine weitere Lösung der genannten Aufgabe besteht erfindungsgemäß darin, daß der aus elektrisch gut-leitendem Material bestehende Kälteschild durch rohrförmige Endstücke an den beiden Stirnseiten und aus mindestens einem sich zwischen diesen Endstücken erstreckenden, zumindest den Bereich der Gradientenspulen überdeckenden rohrförmigen Zwischenstück gebildet ist, wobei die Endstücke mit über ihre gesamte axiale Ausdehnung verlaufenden Schlitzen versehen sind.

Auch mit dieser Ausgestaltung der rohrförmigen Endstücke des Kälteschildes lassen sich praktisch die gleichen vorteilhaften Wirkungen erzielen wie mit der vorstehend erwähnten besonderen Materialwahl.

Vorteilhafte Ausgestaltungen der beiden erfindungsgemäß ausgestalteten Magnetsysteme gehen aus den Unteransprüchen hervor.

Zur weiteren Erläuterung der Erfindung wird nachfolgend auf die Zeichnung Bezug genommen, in deren Figur 1 eine erste Ausbildungsmöglichkeit eines erfindungsgemäßen Magnetsystems mit einem Kälteschild angedeutet ist. Figur 2 zeigt als Diagramm eine axiale Kraftdichteverteilung auf den Kälteschild dieses Magnetsystems. In Figur 3 ist eine weitere Ausbildungsmöglichkeit eines Kälteschildes für ein erfindungsgemäßes Magnetsystem veranschaulicht.

Bei dem erfindungsgemäßen Magnetsystem wird von bekannten Ausführungsformen ausgegangen, wie sie als Grundfeldmagnete für bildgebende Anlagen zur Kernspintomographie vorgesehen werden (vgl. z.B. EP-B-0 011 335 oder EP-A-0 056 691). Ein solches Magnetsystem enthält dabei mindestens ein Paar von supraleitenden Einzelspulen an den Stirnseiten zur Erzeugung eines magnetischen Grundfeldes in Richtung der z-Achse eines rechtwinkligen x-y-z-Koordinatensystems. Dieses Grundfeld ist in einem Abbildungsbereich, in dessen zentraler Mitte M sich der Koordinatenursprung dieses Koordinatensystems befinden soll, hinreichend homogen. Das Magnetsystem soll einen axialen Zugang zu diesem homogenen Abbildungsbereich erlauben; d.h., ein zu untersuchender, beispielsweise menschlicher Körper wird längs der z-Achse in den Feldbereich eingebracht. Entsprechende Grundfeldmagnete werden deshalb vorzugsweise rotationssymmetrisch aus ringförmigen Einzelspulen aufgebaut.

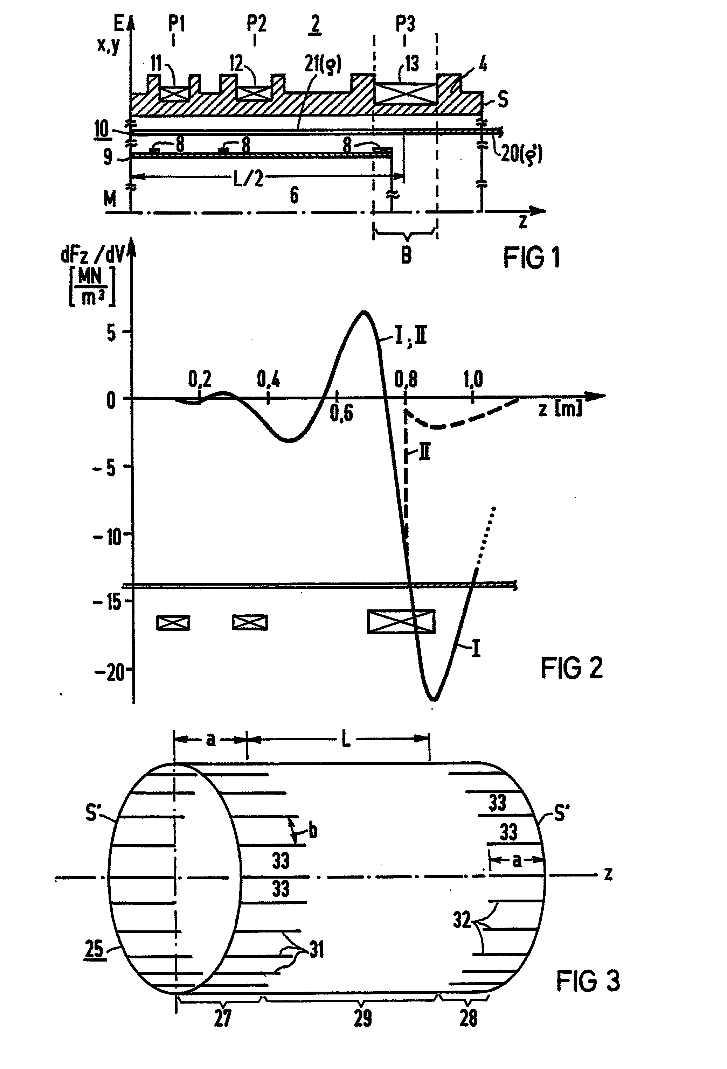

Das in Figur 1 nur schematisch angedeutete und allgemein mit 2 bezeichnete Magnetsystem eines entsprechenden Grundfeldmagneten zur Kernspintomographie soll sechs längs der z-Achse hintereinandergereihte, ringförmige supraleitende Einzelspulen aufweisen. Jeweils zwei dieser Einzelspulen sind bezüglich der durch die x-y-Achse des Koordinatensystems aufgespannten Ebene E symmetrisch angeordnet, so daß sich drei Paare P1, P2 und P3 von Einzelspulen ergeben. In der Figur sind nur die auf der einen Seite dieser Symmetrieebene E und oberhalb der z-Achse liegenden Teile des Magnetsystems näher ausgeführt. Somit sind das innere, der Symmetrieebene E zugewandte Spulenpaar P1 durch seine Einzelspule 11, das äußerste, den Stirnseiten S zugewandte Spulenpaar P3 nur durch seine Einzelspule 13 und das dazwischenliegende, mittlere Einzelspulenpaar P2 durch seine Einzelspule 12 veranschaulicht. Dabei können die Einzelspulen des Magnetsystems 2 insbesondere in entsprechenden Nuten eines massiven, hohlzylindrischen Spulenkörpers 4 aus nicht-magnetischem Material angeordnet sein. Um die für die Kernspintomographie zu fordernden Homogenitätsverhältnisse zu gewährleisten, müssen dabei die Einzelspulen 13 des stirnseitigen Spulenpaares P3 eine wesentlich größere Amperewindungszahl aufweisen als die Einzelspulen 11 und 12 der beiden übrigen Spulenpaare P1 bzw. P2.

Innerhalb des von den Spulenpaaren P1 bis P3 bzw. ihrem gemeinsamen Spulenkörper 4 begrenzten zylindrischen Innenraums 6 des Magnetsystems 2 sind außerdem an sich bekannte normalleitende Gradientenspulen und ferner normalleitende HF-Spulen anzuordnen. In der Figur sind lediglich beispielsweise sattelförmige x-y-Gradientenspulen angedeutet und mit 8 bezeichnet.

Diese beispielsweise auf einem rohrförmigen Träger 9 befestigten Gradientenspulen 8 befinden sich auf Raumtemperatur, so daß eine thermische Abschirmung zwischen ihnen und den tiefgekühlten supraleitenden Einzelspulen 11 bis 13 zweckmäßig ist. Hierzu dient ein im Querschnitt ringförmiger Vakuumraum, in dem mindestens ein vielfach auch als thermischer Strahlungsschild bezeichneter Kälteschild 10 angeordnet ist. Dieser rohrförmig ausgebildete Kälteschild 10, der aus einem Material mit einer hinreichend guten thermischen Leitfähigkeit bestehen muß, wird dabei auf einem Temperaturniveau zwischen der Raumtemperatur der Gradientenspule 8 und der Tiefsttemperatur der supraleitenden Einzelspulen 11 bis 13 gehalten. Hierzu kann er an Teile des Magnetsystems mit entsprechender Temperatur von beispielsweise 50 K oder 80 K thermisch angekoppelt sein. Erfindungsgemäß ist der Kälteschild 10 in axialer Richtung in einzelne rohrförmige Teile segmentiert, wobei die den Stirnseiten S zugewandten Endstücke mit 20 und das mindestens eine zwischen den Endstücken sich erstreckende Zwischenstück mit 21 bezeichnet sind. Vorteilhaft wird dabei die gesamte axiale Mindestausdehnung L des Zwischenstückes 21 so gewählt, daß es zumindest weitgehend die Gradientenspulen 8 gegenüber den supraleitenden Einzelspulen 11 bis 13 abschirmt. Dabei sollte es jedoch an den Stirnseiten jeweils nur an einen Bereich B heranreichen oder in diesen Bereich hineinreichen, der durch die axiale Ausdehnung der stirnseitigen Spulen 13 des äußersten Spulenpaares P3 festgelegt ist. Das Zwischenstück 21 wird außerdem vorteilhaft aus einem Material mit guter elektrischer und thermischer Leitfähigkeit hergestellt. Insbesondere ist hier für Aluminium mit einer Reinheit von 99,5 % geeignet, das bei 80 K einen spezifischen elektrischen Widerstand $\rho$ (80 K) von ungefähr $3 \times 10^{-9}$ Ω· m aufweist.

Demgegenüber sollen gemäß einer ersten Ausbildungsmöglichkeit der Erfindung die stirnseitigen Endstücke 20 des Kälteschildes 10 aus einem Material bestehen, das einen vergleichsweise wesentlich größeren spezifischen elekrischen Widerstand $\rho'$(80 K) bei der genannten Temperatur hat als das Material des Zwischenstücks 21. Vorzugsweise soll der spezifische elektrische Widerstand $\rho'$(80 K) des Materials der Endstücke mindestens 5 mal, vorzugsweise mindestens eine 10er-Potenz größer sein. So ist beispielsweise die Aluminiumlegierung AlMg4,5 geeignet, deren $\rho'$(80 K) bei etwa $3 \times 10^{-8}$ Ω·m liegt.

Der in Figur 1 angedeutete Kälteschild 10 läßt sich beispielsweise dadurch ausbilden, daß man die einzelnen Teile 20 und 21 unmittelbar aneinanderfügt, z.B. miteinander verschweißt. Auch können diese Teile auf oder in einem gemeinsamen hohlzylindrischen Trägerkörper aus nicht-leitendem Material wie z.B. glasfaserverstärktem Kunststoff angeordnet werden. Darüber hinaus ist es auch möglich, ein durchgehendes Tragrohr aus dem schlechter leitenden Material der Endstücke 20 vorzusehen, in oder auf welches dann mindestens ein rohrförmiges Zwischenstück 21 aus dem gut-leitenden Material mit angepaßtem Durchmesser geschoben und anschließend befestigt wird. Auf jeden Fall sollte aber eine hinreichend gute thermische Verbindung zwischen den Endstücken 20 und dem mindestens einen Zwischenstück 21 gewährleistet sein.

Eine in einem Magnetsystem 2 gemäß Figur 1 mit einem Kälteschild hervorgerufene axiale Kraftdichteverteilung $dF_z/dV = j\phi$. $B_r$ geht aus dem Diagramm der Figur 2 hervor. Dabei sind $F_z$ die axiale Kraft, V das betrachtete Volumen, $j\phi$ der im Kälteschild angeworfene Wirbelstrom und $B_r$ die radiale, in einer x-y-Ebene liegende Komponente der magnetischen Induktion. Für die Abszisse z ist derselbe Maßstab wie für die Darstellung nach Figur 1 gewählt. In Ordinatenrichtung ist die zugehörige Kraftdichteverteilung $dF_z/dV$ aufgetragen. Hierbei wurde ein bekannter 2 Tesla-Grundfeldmagnet mit 3 Paaren P1 bis P3 supraleitender Einzelspulen 11 bis 13 von jeweils etwa 1,2 m Innendurchmesser zugrundegelegt. Der Kälteschild 10 hat dabei einen Innendurchmesser von etwa 1,1 m. Diese Teile des Magnetsystems sind in die Figur mit ihren jeweiligen ungefähren axialen Positionen bzw. Abmessungen mit eingezeichnet. Sieht man nun als Kälteschild einen entsprechenden, nicht erfindungsgemäß axial segmentierten Hohlzylinder aus Reinaluminium mit 6 mm Wandstärke vor, so ergibt sich 2,5 sec nach einem Quench einer der stirnseitigen supraleitenden Endspulen 13 eine Kraftdichteverteilung, die der durchgezogenen Kurve I des Diagramms entspricht. Wie aus dem Kurvenverlauf ersichtlich, ändert die in dem angenommenen Quenchzeitpunkt hervorgerufene Kraftkomponente $F_z$ wie die Radialkomponente $B_r$ ihr Vorzeichen entlang dem Kälteschild, wobei ein ganz erheblicher maximaler Beitrag in der Nähe des axialen Endes dieses Schildes erreicht wird. Aus diesem Grunde sind dort erfindungsgemäß die besonderen Endstücke 20 aus elektrisch schlechter leitendem Material wie z.B. AlMg4,5 vorgesehen, um den angeworfenen Wirbelstrom $j\phi$ zu verringern. Mit der genannten Legierung AlMg4,5 ist für den zugrundegelegten Grundfeldmagneten eine Verringerung auf etwa 1/10 zu erreichen. Die dann resultierende Kraftverteilung bei Verwendung solcher besonderer Endstücke ist in dem Diagramm durch eine gestrichelte Linie II mit eingezeichnet, die für den Bereich z ≤ L/2 mit der Kurve I übereinstimmt.

Bei dieser Kraftverteilung ist die Nettokraft auf den Kälteschild zu dem angenommenen Zeitpunkt minimal.

Bei der Darstellung nach den Figuren 1 und 2 wurde von einem axial segmentierten Kälteschild 10 ausgegangen, dessen rohrförmige Endstücke 20 eine erheblich geringere elektrische Leitfähigkeit aufweisen als das zwischen ihnen liegende rohrförmige Zwischenstück 21. Eine entsprechende Wirkung dieser Maßnahme hinsichtlich einer Unterdrückung von bei einem Quench induzierten Wirbelströmen und einer damit verbundenen Kraftwirkung läßt sich auch dadurch erreichen, daß man Endstücke nicht aus besonderem Material vorsieht, sondern diese in bestimmter Weise schlitzt. Eine entsprechende Ausbildungsmöglichkeit für einen Kälteschild ist in Figur 3 schematisch als Schrägansicht veranschaulicht. Die geometrischen Abmessungen dieses allgemein mit 25 bezeichneten, rohrförmigen Kälteschildes und seiner einzelnen Abschnitte entsprechen dabei zumindest weitgehend denen des Kälteschildes 10 (mit Teilen 20, 21) nach Figur 1. Der Kälteschild 25 kann vorteilhaft über seine gesamte axiale Länge aus einem einheitlichen, elektrisch gut leitenden Material wie Reinaluminium bestehen. Er weist besonders geschlitzte, stirnseitige Endstücke 27 und 28 auf, während sein dazwischenliegendes Zwischenstück 29 der axialen Länge L nicht-geschlitzt ist. Die einzelnen, beispielsweise von den Stirnseiten S' des Schildes 25 her eingesägten Schlitze 31 bzw. 32 erstrecken sich dabei vorteilhaft in zumindest weitgehend axialer, d.h. z-Richtung, wobei sie die entsprechende Ausdehnung a der Endstücke 27 und 28 festlegen. Sie sind über den Umfang des jeweiligen Endstückes regelmäßig verteilt angeordnet. Ihre Anzahl wird vorteilhaft so gewählt, daß zwischen benachbarten Schlitzen Segmente 33 aus dem Material des Kälteschildes 25 verbleiben, deren Breite b in Umfangsrichtung höchstens gleich der axialen Ausdehnung a der Schlitze ist. Vorzugsweise wird eine Segmentbreite b ≤ 1/2 • a vorgesehen. Auf diese Weise werden die Län gen der Strompfade wesentlich vergrößert und somit die bei einem Quench induzierten Ströme entsprechend verringert.

**Patentansprüche**

1. Magnetsystem (2) einer Anlage zur Kernspintomographie mit mindestens einem Paar (P1; P2; P3) ringförmiger supraleitender Einzelspulen (11; 12; 13) zur Erzeugung eines homogenen magnetischen Grundfeldes, wobei zumindest die an den beiden Stirnseiten (S) des Magnetsystems (2) befindlichen supraleitenden Einzelspulen (13) jeweils mit einer Schutzvorrichtung für den Fall eines unbeabsichtigten Normalleitendwerdens (Quench) elektrisch überbrückt sind, mit normalleitenden Spulen (8) zur Ausbildung magnetischer Feldgradienten sowie mit einem hohlzylindrischen Kälteschild (10) aus normalleitendem Material, der zwischen den Gradientenspulen (8) und den supraleitenden Einzelspulen (11; 12; 13) angeordnet und in axialer Richtung (z) zumindest bis zu den beiden Strinseiten (S) augedehnt ist, dadurch gekennzeichnet, daß der Kälteschild (10) an den beiden Stirnseiten (S) durch rohrförmige Endstücke (20) gebildet ist, deren Material einen vorbestimmten spezifischen elektrischen Widerstand (δ') hat, der bei Betriebstemperatur des Kälteschildes (10) größer ist als der spezifische elektrische Widerstand (δ) des Materials, aus dem mindestens ein sich zwischen den Endstücken (20) ersteckendes, zumindest den Bereich der Gradientenspulen (8) überdeckendes rohrförmiges Zwischenstück (21) des Kälteschildes (10) besteht.

2. Magnetsystem nach Anspruch 1, dadurch gekennzeichnet, daß der spezifische elektrische Widerstand (δ') des Materials der Endstücke (20) mindestens das 5fache, vorzugsweise mindestens das 10fache des spezifischen elektrischen Widerstandes (δ) des Materials des Zwischenstücks (21) beträgt.

3. Magnetsystem nach Anspruch 1 oder 2, dadurch gekennzeichnet, daß der Kälteschild (10) durch ein bis an die Stirnseiten (S) reichendes, durchgehendes Rohr aus dem Material der Endstücke (20) gebildet ist, in dem oder um das das rohrförmige Zwischenstück (21) konzentrisch angeordnet ist.

4. Magnetsystem nach einem der Ansprüche 1 bis 3, dadurch gekennzeichnet, daß das Zwischenstück (21) aus Aluminium hoher Reinheit und die Endstücke (20) aus einer Aluminiumlegierung bestehen.

5. Magnetsystem (2) einer Anlage zur Kernspintomographie mit mindestens einem Paar (P1; P2; P3) ringförmiger supraleitender Einzelspulen (11; 12; 13) zur Erzeugung eines homogenen Grundfeldes, wobei zumindest die an den beiden Stirnseiten (S) des Magnetsystems (2) befindlichen supraleitenden Einzelspulen (13) jeweils mit einer Schutzvorrichtung für den Fall eines unbeabsichtigten Normalleitendwerdens (Quench) elektrisch überbrückt sind, mit normalleitenden Spulen (8) zur Ausbildung magnetischer Feldgradienten sowie mit einem hohlzylindrischen Kälteschild (25) aus normalleitendem Material der zwischen den Gradientenspulen (8) und den supraleitenden Einzelspulen (11; 12; 13) angeordnet und in axialer Richtung (z) zumindest bis zu den beiden Stirnseiten (S) ausgedehnt ist, dadurch gekennzeichnet, daß der aus elektrisch gut-leitendem Material bestehende Kälteschild (25) durch rohrförmige Endstücke (27, 28) an den beiden Stirnseiten (S') und aus mindestens einem sich zwischen diesen Endstücken (27, 28) erstreckenden, zumindest den Bereich der Gradientenspulen (8) überdeckenden rohrförmigen Zwischenstück (29) gebildet ist, wobei die Endstücke (27, 28) mit über ihre gesamte axiale Ausdehnung (a) verlaufenden Schlitzen (31, 32) versehen sind.

6. Magnetsystem nach Anspruch 5, dadurch gekennzeichnet, daß die Enstücke (27, 28) mit einer solchen Anzahl von über ihren Umfang regelmäßig verteilten Schlitzen (31 bzw. 32) versehen sind, daß die Breite (b) in Umfangsrichtung der verbleibenden Segmente (33) aus dem elektrisch gut leitenden Material höchstens gleich der axialen Ausdehnung (a) der Schlitze (31, 32) ist.

7. Magnetsystem nach Anspruch 6, dadurch gekennzeichnet, daß die Breite (b) der Segmente (33) höchstens die Hälfte der axialen Ausdehnung (a) der Schlitze (31, 32) beträgt.

8. Magnetsystem nach einem der Ansprüche 5 bis 7, dadurch gekennzeichnet, daß die Schlitze (31, 32) in den Kälteschild (25) von dessen Strinseiten (S') her eingearbeitet sind.

9. Magnetsystem nach einem der Ansprüche 1 bis 8, dadurch gekennzeichnet, daß das Zwischenstück (21, 29) axial jeweils bis an oder in einen Bereich (B) reicht, der durch die axiale Ausdehnung der jeweiligen supraleitenden Einzelspule (13) festgelegt ist.

10. Magnetsystem nach Anspruch 9, dadurch gekennzeichnet, daß das Zwischenstück (21, 29) an seinen beiden axialen Enden jeweils in die Nähe der axialen Mitte des jeweiligen Bereichs (B) reicht.

**Revendications**

1. Système magnétique (2) d'une installation de tomographie à spin nucléaire comportant au moins un couple (P1; P2; P3) de bobines individuelles supraconductrices annulaires (11; 12; 13) servant à produire un champ magnétique homogène de base, et dans lequel au moins chacune des bobines individuelles supraconductrices (13) situées sur les deux côtés frontaux (S) du système magnétique (2), est shuntée électriquement au moyen d'un dispositif de protection pour le cas d'un passage intempestif à l'état de conduction normale (quench), et comportant des bobines à conduction normale (8) servant à créer des gradients magnétiques de champ, ainsi qu'un bouclier thermique pour basses températures (10) en forme de cylindre creux, réalisé en un matériau à conduction normale, disposé entre les bobines de gradients (8) et les bobines individuelles supraconductrices (11; 12; 13) et s'étendant, dans la direction axiale (z), au moins jusqu'aux deux côtés frontaux (S), caractérisé par le fait que le bouclier thermique pour basses températures (10) est constitué sur les deux côtés frontaux (S) par des pièces d'extrémité tubulaires (20), dont le matériau possède une résistance électrique spécifique prédéterminée (δ'), qui, à la température de fonctionnement du bouclier thermique pour basses températures (10), est supérieure à la résistance électrique spécifique (δ) du matériau avec lequel est constituée au moins une pièce intermédaire de forme tubulaire (21) du bouclier thermique pour basses températures (10), qui s'étend entre les pièces d'extrémité (20) et qui recouvre au moins la zone des bobines de gradients (8).

2. Système magnétique suivant la revendication 1, caractérisé par le fait que la résistance électrique spécifique (δ') du matériau des pièces d'extrémité (20) est égale au moins au quintuple et de préférence au moins au décuple de la résistance électrique spécifique (δ) de la pièce intermédiaire (21).

3. Système magnétique suivant la revendication 1 ou 2, caractérisé par le fait que le bouclier thermique pour basses températures (10) est formé par un tube continu qui s'étend jusqu'aux côtés frontaux (S) et qui est constitué par le matériau des pièces d'extrémité (20), et dans lequel ou autour duquel la pièce intermédiaire de forme tubulaire (21) est disposée concentriquement.

4. Système magnétique suivant l'une des revendications 1 à 3, caractérisé par le fait que la pièce intermédiaire (21) est constiuée par de l'aluminium très pur et que les pièces d'extrémité (20) sont constituées par un alliage d'aluminium.

5. Système magnétique (2) d'une installation de tomographie à spin nucléaire comportant au moins un couple (P1; P2; P3) de bobines individuelles supraconductrices annulaires (11; 12; 13) servant à produire un champ homogène de base, et dans lequel au moins chacune des bobines individuelles supraconductrices (13) situées sur les deux côtés frontaux (S) du système magnétique (2), est shuntée électriquement au moyen d'un dispositif de protection pour le cas d'un passage intempestif à l'état de conduction normale quench, et comportant des bobines à conduction normale (8) servant à créer des gradients magnétiques de champ ainsi qu'un bouclier thermique pour basses températures (25) en forme de cylindre creux, réalisé en un matériau à conduction normale, disposé entre les bobines de gradients (8) et les bobines individuelles supraconductrices (11; 12; 13) et s'étendant, dans la direction axiale (z), au moins jusqu'aux deux côtés frontaux (S), caractérisé par le fait que le bouclier thermique pour basses températures (25), constitué par un matériau bon conducteur de l'électricité, est formé par des pièces d'extrémité de forme tubulaire (27, 28), situées sur les deux côtés frontaux (S') et par au moins une pièce intermédiaire de forme tubulaire (29) qui s'étend entre ces pièces d'extrémité (27, 28) et qui recouvre au moins la zone des bobines de gradients (8), les pièces d'extrémité (27, 28) comportant des fentes (31, 32) s'étendant sur toute leur extension axiale (a).

6. Système magnétique suivant la revendication 5, caractérisé par le fait que les pièces d'extrémité (27, 28) sont pourvues d'un tel nombre de fentes (31 ou 32), réparties uniformément sur leur pourtour, que la largeur (b) dans la direction circonférentielle des segments (33) qui subsistent, constituées par le matériau bon conducteur d'électricité, est égale au maximum à l'extension axiale (a) des fentes (31, 32).

7. Système magnétique suivant la revendication 6, caractérisé par le fait que la largeur (b) des segments (33) est égale au maximum à la moitié de l'extension axiale (a) des fentes (31, 32).

8. Système magnétique suivant l'une des revendications 5 à 7, caractérisé par le fait que les fentes (31, 32) sont ménagées par usinage dans le bouclier thermique pour basses températures (24), à partir des côtés frontaux (S') de ce dernier.

9. Système magnétique suivant l'une des revendications 1 à 8, caractérisé par le fait que la pièce intermédiaire (21, 29) s'étend axialement respectivement jusqu'à ou dans une zone (B), qui est déterminée par l'extension axiale de la bobine individuelle supraconductrice respective (13).

10. Système magnétique suivant la revendication 9, caractérisé par le fait que la pièce intermédiaire (21, 29) s'étend, au niveau de ses deux extrémités axiales, respectivement à proximité du milieu de la zone respective (B).

**Claims**

1. Magnetic system (2) of an installation for nuclear spin tomography with at least one pair (P1; P2; P3) of annular superconducting single coils (11; 12; 13) for the production of a homogeneous magnetic basic field, wherein at least the superconducting single coils (13) located at the two end sides (S) of the magnetic system (2) in each case are electrically bridged over with a protective device for the case of unintentionally becoming normally conducting (quench), with normally conducting coils (8) for the formation of magnetic field gradients and with a hollow cylindrical cold shield (10) consisting of normally conducting material, which is arranged between the gradient coils (8) and the superconducting single coils (11; 12; 13) and is extended in axial direction (z) at least to the two end sides (S), characterized in that the cold shield (10) at the two end sides (S) is formed by tubular end pieces (20), the material of which has a predetermined specific electrical resistance (δ'), which at the operational temperature of the cold shield (10) is greater than the specific electrical resistance (δ) of the material of which at least one tubular intermediate piece (21) of the cold shield (10) consists, this intermediate piece extending between the end pieces (20) and covering over at least the region of the gradient coils (8).

2. Magnetic system according to claim 1, characterized in that the specific electrical resistance ($\delta'$) of the material of the end pieces (20) amounts to at least 5 times, preferably at least 10 times the specific electrical resistance ($\delta$) of the material of the intermediate piece (21).

3. Magnetic system according to claim 1 or 2, characterized in that the cold shield (10) is formed by a continuous pipe, reaching up to the end sides (S), consisting of the material of the end pieces (20), in which or around which the tubular intermediate piece (21) is concentrically arranged.

4. Magnetic system according to one of claims 1 to 3, characterized in that the intermediate piece (21) consists of aluminium of a high purity and the end pieces (20) consist of an aluminium alloy.

5. Magnetic system (2) of an installation for nuclear spin tomography with at least one pair (P1; P2; P3) of annular superconducting single coils (11; 12; 13) for the production of a homogeneous basic field; wherein at least the superconducting single coils (13) located at the two end sides (S) of the magnetic system (2) in each case are electrically bridged over with a protective device for the case of unintentionally becoming normally conducting (quench), with normally conducting coils (8) for the formation of magnetic field gradients and with a hollow cylindrical cold shield (25) consisting of normally conducting material, which is arranged between the gradient coils (8) and the superconducting single coils (11; 12; 13) and is extended in axial direction (z) at least up to the two end sides (S), characterized in that the cold shield (25), consisting of material which conducts well electrically, is formed by tubular end pieces (27, 28) on the two end sides (S') and from at least one tubular intermediate piece (29), extending between these end pieces (27, 28) and covering over at least the region of the gradient coils (8), wherein the end pieces (27, 28) are provided with slots (31, 32) extending over their entire axial extent (a).

6. Magnetic system according to claim 5, characterized in that the end pieces (27, 28) are provided with such a number of slots (31 or 32) regularly distributed over their circumference, that the width (b) in the circumfertial direction of the remaining segments (33) consisting of the material which conducts well electrically, is at most the same as the axial extent (a) of the slots (31, 32).

7. Magnetic system according to claim 6, charcterized in that the width (b) of the segments (33) amounts to at most half of the axial extent (a) of the slots (31, 32).

8. Magnetic system according to one of claims 5 to 7, characterized in that the slots (31, 32) are worked into the cold shield (25) from its end sides (S').

9. Magnetic system according to one of claims 1 to 8, characterized in that the intermediate piece (21, 29) reaches axially in each case up to or into a region (B) which is determined by the axial extent of the respective superconducting single coil (13).

10. Magnetic system according to claim 9, characterized in that the intermediate piece (21, 29) at its two axial ends in each case reaches into the vicinity of the axial middle of the respective region (B).

FIG 1

FIG 2

FIG 3